(19) Europäisches Patentamt

European Patent Office

Office européen des brevets

(11) Veröffentlichungsnummer: **0 277 325 B1**

(12) **EUROPÄISCHE PATENTSCHRIFT**

(45) Veröffentlichungstag der Patentschrift: 02.05.91

(51) Int. Cl.⁵: **H05K 3/10, C23C 18/20,** C23C 26/00

(21) Anmeldenummer: 87118519.5

(22) Anmeldetag: 14.12.87

(54) **Verfahren und Beschichtungsmittel zum Aufbringen elektrisch leitender Druckbilder auf isolierende Substrate.**

(30) Priorität: 17.12.86 DE 3643130

(43) Veröffentlichungstag der Anmeldung:
10.08.88 Patentblatt 88/32

(45) Bekanntmachung des Hinweises auf die Patenterteilung:
02.05.91 Patentblatt 91/18

(84) Benannte Vertragsstaaten:
AT BE CH DE FR GB IT LI LU NL SE

(56) Entgegenhaltungen:
WO-A-84/03586
FR-A- 2 160 070

IBM TECHNICAL DISCLOSURE BULLETIN,
Band 15, Nr. 9, Februar 1973, Seite 2855, New York, US; G. KAUS et al.: "Selective metallization of ceramic substrates"

(73) Patentinhaber: **Siemens Aktiengesellschaft Wittelsbacherplatz 2 W-8000 München 2(DE)**

Patentinhaber: **MICHAEL HUBER MÜNCHEN GMBH Feldkirchner Strasse 15 W-8011 Kirchheim-Heimstetten(DE)**

(72) Erfinder: **Fränkel, Jürgen, Dr. Verdistrasse 9 W-8011 Baldham(DE)**
Erfinder: **Mattelin, Antoon Leliestraat 6 B-8020 Oostkamp(BE)**
Erfinder: **Pol, Pecceu Kloosterhof 45 B-8200 Brugge(BE)**
Erfinder: **Quella, Ferdinand, Dr. Cramer-Klett-Strasse 2 W-8014 Neubiberg(DE)**
Erfinder: **Schmidt, Hans F., Dr. Graf-Trattenbachweg 3b W-8191 Eurasburg(DE)**

Erfinder: **Boone, Luc**
**Kortrijkestrasse 171 Bus 3**
**B-8020 Oostkamp(BE)**
Erfinder: **van Tomkewitsch, Sybille**
**Ascheringer Weg 4**
**W-8134 Pöcking(DE)**
Erfinder: **DeVogelaere, Marc**
**Notenbosdreef 5**
**B-8021 Zedelgem(BE)**

(74) Vertreter: **Fuchs, Franz-Josef, Dr.-Ing.**
**Postfach 22 13 17**
**W-8000 München 22(DE)**

EP 0 277 325 B1

**Beschreibung**

Die Erfindung betrifft ein Verfahren zum Aufbringen elektrisch leitender Druckbilder, insbesondere Leiterbilder, auf elektrisch isolierende Susbstrate, bei welchem ein metallhaltiges Beschichtungsmittel unter Einwirkung von Energiestrahlung entsprechend dem zu erzeugenden Druckbild auf das Substrat übertragen und chemisch metallisiert wird sowie ein metallhaltiges Beschichtungsmittel zum Aufbringen elektrisch leitender Druckbilder auf elektrisch isolierende Substrate.

Ein derartiges Verfahren zum Aufbringen von Leiterbildern auf elektrisch leitende Substrate, bei welchem die Übertragung des Leiterbildes mit Hilfe eines Lasers vogenommen wird, ist aus der DE-Z "Galvanotechnik" 77 (1986) Nr. 1, Seiten 51 bis 60 bereits bekannt. Als Substrat wird ein kleberbeschichtets Epoxidharz-Basismaterial verwendet, welches zunächst zur Aufrauhung des Klebers einer Vorbehandlung durch $SO_3$-Gasphasenbeizung mit $NH_3$-Beizstop unterzogen wird. Als metallhaltiges Beschichtungsmittel wird dann beispielsweise ein Cr(III)-Fotosensitizer auf das Substrat aufgebracht, der Chrom(III)-chlorid, Natriumoxalat und Palladium (II)-chlorid enthält. Bei der anschließenden Laser-Bildübertragung entstehen dann im Bereich des Leiterbildes Pd-Keime, die nach einer Vormetallisierung mit Ni-P und einer Wärmebehandlung bei 100 bis 120° C eine chemische oder galvanische Dickverkupferung ermöglichen. Insbesondere bei der Dickverkupferung in außenstromlos arbeitenden Kupferbädern kann es bei längeren Expositionzeiten zu Ablösungen der Kleberschicht vom Basismaterial kommen, so daß die abgeschiedenen Leiterbahnen ihre Haftgrundlage verlieren.

Aus "IBM Technical Disclosure Bulletin" Band 15, Nr. 9, Februar 1973, Seite 2855 ist ein Verfahren zum Aufbringen von Leiterbildern auf Keramiksubstrate bekannt, bei welchem zunächst ein metallhaltiger thermoplastischer Puder auf die grüne Keramik aufgebracht wird und anschließend entsprechend dem gewünschten Leiterbild der Einwirkung eines Laserstrahls ausgesetzt wird. Durch den Laserstrahl wird die thermoplastische Phase derart aufgeschmolzen, daß die Metallpartikel eingebettet werden und an dem Keramiksubstrat anhaften. Das nicht dem Laserstrahl ausgesetzte metallhaltige Pulver kann dann beispielsweise mittels eines Luftstrahls entfernt werden.

Der Erfindung liegt die Aufgabe zugrunde, ein Verfahren zum Aufbringen elektrisch leitender Druckbilder, insbesondere Leiterbilder auf elektrisch isolierende Substrate zu schaffen, das eine einfache Übertragung des Druckbildes ermöglicht und insbesondere bei der Herstellung von Leiterplatten den Aufbau sehr feiner Leiterstrukturen mit ausreichender Haftgrundlage gewährleistet. Weiterhin soll eine hierfür geeignetes, metallhaltiges Beschichtungsmittel angegeben werden.

Diese Aufgabe wird bei einem Verfahren der eingangs genannten Art erfindungsgemäß dadurch gelöst, daß als Beschichtungsmittel eine nichtmetallische, körnige Trägersubstanz mit darauf aufgebrachtem Metall der Oxidationsstufe Null verwendet wird.

Der Erfindung liegt die Erkenntnis zugrunde, daß die durch Energiestrahlung induzierte Zersetzung metallorganischer Verbindungen durch den Einsatz von Metall der Oxidationsstufe Null umgangen werden kann, sofern das Metall in einer für die Übertragung des Druckbildes und die feste Verankerung auf oder in dem Substrat geeignete Weise aufbereitet werden kann. Diese Aufbereitung des Metalles der Oxidationsstufe Null erfolgt durch die Verwendung einer nichtmetallischen, körnigen Trägersubstanz, auf die das Metall in fein verteilter Form aufgebracht wird. Derartige Trägersubstanzen für Metalle der Oxidationsstufe Null sind im übrigen als sog. Trägerkatalysatoren bereits bekannt, die beispielsweise bei der Hydrierung oder Dehydrierung eingesetzt werden. Bei der Herstellung derartiger Trägerkatalysatoren werden Katalysatormetalle wie Platin, Paladium and Nickel auf Katalysatorträger wie Aktivkohle, Kieselgur, Bentonite, Kaoline, Kieselgel, Aluminiumoxid und Bimsstein niedergeschlagen. Handelsübliche Trägerkatalysatoren enthalten im allgemeinen zwischen 0,5 und 60 Gw.-% Metall.

Durch die Verwendung der auf körnige Trägersubstanzen aufgebrachten Metalle als Beschichtungsmittel ergibt sich auf dem Substrat eine dreidimensionale Verteilung der Metallkeime, welche die nachfolgende chemische Metallisierung begünstigt und die Expositionszeiten in den entsprechenden außenstromlos arbeitenden Bädern erheblich verringert. Außerdem ermöglichen die körnigen Trägersubstanzen eine sehr gute und durch die Einwirkung von Energiestrahlung steuerbare Verankerung im Substrat, die dann beispielsweise bei der Herstellung von Leiterplatten eine vorzügliche Haftgrundlage für die Leiterbahnen gewährleistet. Als weitere Vorteile sind die geringe Umweltbelastung durch den Wegfall der bislang erforderlichen Zersetzungsreaktionen, die durch die Vereinfachung des Verfahrens erzielbare höhere Wirtschaftlichkeit und die Möglichkeit einer Verarbeitung des Beschichtungsmittels in flüssiger Form anzuführen. Letzteres wird dadurch ermöglicht, daß die an Trägersubstanzen gebundenen Metalle in Flüssigkeiten sehr gut dispergiert werden können und zu stabilen flüssigen Beschichtungsmitteln führen.

Vorteilhafte Ausgestaltungen des erfindungsgemäßen Verfahrens gehen aus den Unteransprüchen 2 bis 48 hervor.

3

Die Erfindung gibt auch ein metallhaltiges Beschichtungsmittel zum Aufbringen elektrisch leitender Druckbilder, insbesondere Leiterbilder auf elektrisch isolierende Substrate an, bei welcher das Metall in der Oxidationsstufe Null auf eine nichtmetallische, körnige Trägersubstanz aufgebracht ist. Durch die Verwendung dieser erfindungsgemäßen Beschichtungsmittel bei der Bildübertragung mittels Energiestrahlen ergeben sich die bereits vorstehend aufgeführten Vorteile.

Das erfindungsgemäße Verfahren und das erfindungsgemäße Beschichtungsmittel ermöglichen prinzipiell eine Vielzahl von Verarbeitungsformen und Übertragungsformen. So kann das Beschichtungsmittel in fester Form als Pulver mit oder ohne Bindemittel, in flüssiger Form oder in Form einer auf die Substratoberfläche aufzubringenden Folie verarbeitet werden. Die Folie kann dann allein aus dem Beschichtungsmittel bestehen oder aus dem Beschichtungsmittel und einem Hilfsträger zusammengesetzt sein. Geeignete Techniken für die Übertragung von Druckbildern mittels Folien gehen beispielsweise aus der FR-OS 2 250 318 hervor. Die Übertragung der Druckbilder unter Einwirkung von Energiestrahlung kann ebenfalls auf verschiedene Weise vorgenommen werden. Neben der Verwendung von Masken, Stempeln und drgl. können die Druckbilder auch durch Relativbewegungen zwischen Energiestrahl und Substrat erzeugt werden. Ferner ist noch darauf hinzuweisen, daß unter der Übertragung von Druckbildern auch ganzflächige Metallisierungen von Substraten zu verstehen sind. In diesem Fall können dann auch Subtraktivtechniken zum Einsatz kommen.

Vorteilhafte Ausgestaltungen des erfindungsgemäßen Beschichtungsmittels gehen aus den Unteransprüchen 47 bis 50 hervor.

Ausführungsbeispiele der Erfindung sind in der Zeichnung dargestellt und werden im folgenden näher beschrieben.

Es zeigen:

Fig 1 eine Anordnung zur Durchführung des erfindungsgemäßen Verfahrens,

Fig 2 das Prinzip der Laser-Bildübertragung unter Verwendung eines erfindungsgemäßen Beschichtungsmittels,

Fig 3 das Prinzip der Verankerung der Trägersubstanz im Substrat,

Fig 4 das gemäß den FIG 2 und 3 übertragene und im Substrat verankerte Leiterbild,

Fig 5 das Leiterbild gemäß FIG 4 nach einer chemischen und galvanischen Metallisierung,

Fig 6 eine Variante bei welcher das Beschichtungsmittel einen Schmelzklebstoff als Bindemittel enthält und

Fig 7 die Verankerung des Leiterbildes im Substat bei der Variante gemäß FIG 6

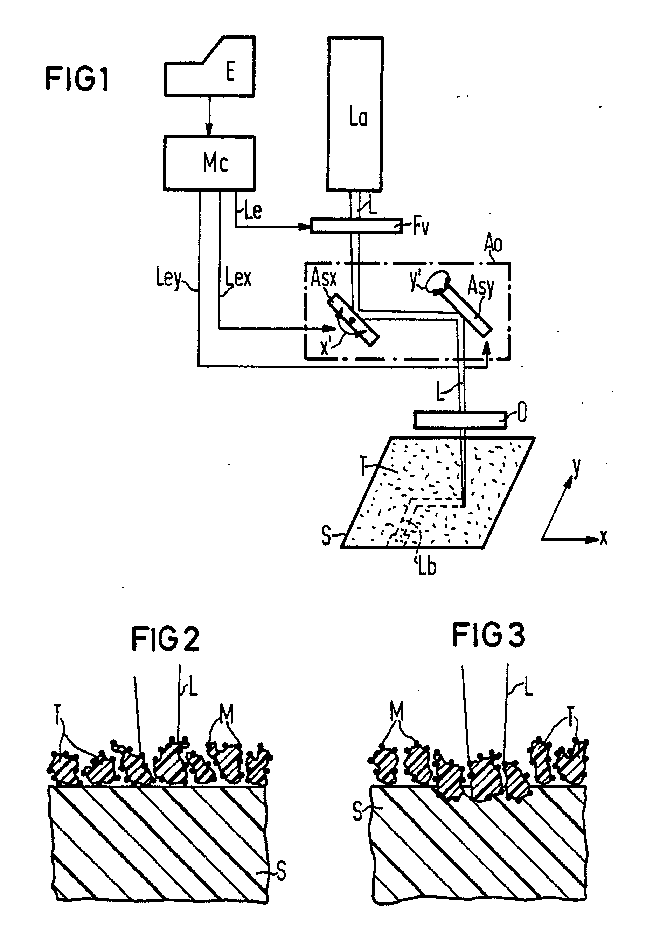

FIG 1 zeigt in stark vereinfachter schematischer Darstellung eine Anordnung zur Übertragung eines Leiterbildes auf ein Substrat S, das beispielsweise aus einem thermoplastischen Kunststoff besteht. Bei dem dargestellten Substrat S handelt es sich um einen Ausschnitt eines Basismaterials für spritzgegossene Leiterplatten. Als Materialien für derartige Basismaterialien sind insbesondere hochtemperaturbeständige Thermoplaste wie Polyetherimid, Polyethersulfon, Polyphenylensulfid und Flüssigkristallpolymere geeignet. Auf die Oberfläche des Substrats S ist in einer Schichtdicke von etwa 4 $\mu$m ein Beschichtungsmittel aufgebracht, dessen körnige Trägersubstanz T durch winzige Punkte aufgezeigt ist.

Die dargestellte Anorndung umfaßt einen Laser La, welcher einen Laserstrahl L erzeugt, in dessen Strahlengang aufeinanderfolgend ein Fotoverschluß Fv, ein erster drehbarer Ablenkspiegel Asx einer Ablenkoptik Ao, ein zweiter drehbarer Ablenkspiegel Asy der Ablenkoptik Ao und ein Objektiv O angeordnet sind, welches den Laserstrahl L auf die Oberfläche des Substrats S fokussiert. Die Lage des Substrats S ist in bezug auf ein ebenes kartesisches x-, y-Koordinatensystem festgelegt. Dementsprechend hat der erste Ablenkspiegel Asx der Ablenoptik Ao die Aufgabe, den Laserstrahl L in der horizontalen Richtung x abzulenken, was in FIG 1 durch einen Doppelpfeil x' angedeutet ist. Der zweite Ablenkspiegel Asy der Ablenkoptik Ao hat die Aufgabe, den Laserstrahl Ls in der vertikalen Richtung y abzulenken, was in FIG 1 durch einen Doppelpfeil y' angedeutet ist.

Die Steuerung der Ablenkspiegel Asx und Asy entsprechen dem jeweils auf dem Substrat zu erzeugenden Leiterbild erfolgt durch einen Mikrocomputer Mc, welchem eine Eingabe E zugeordnet ist. Die Leitungen für die Steuerung der Ablenkspiegel Asx und Asy sind dabei mit Lex bzw. Ley bezeichnet. Der Mikrocomputer Mc steuert auch den Fotoverschluß Fv, was durch eine entsprechende Leitung Le aufgrezeigt ist.

Bei dem Laser La handelt es sich beispielsweise um einen $CO_2$-Laser, der im Dauerstrichbetrieb eingesetzt oder auch elektronisch gepulst werdenkann, wobei die mittlere Leistung zwischen 0,5 Watt und 8 Watt liegt. Die Fokussierung des Laserstrahls L ist verstellbar, wobei der Durchmesser des Laserstrals L an der Substratoberfläche auf Durchmesser zwischen 50 $\mu$m und 400 $\mu$m eingestellt werden kann.

Für die Übertragung des Leiterbildes auf das Substrat S wird die darauf aufgebrachte Druckfarbe vom Laserstrahl L entsprechend der über die Eingabe E in den Mikrocomputer Mc eingegebenen Leiterbahnkonfiguration bestrichen. Als Spur des Laserstrahls L bei der Leiterbildübertragung ist in FIG 1 eine mit Lb

EP 0 277 325 B1

bezeichnete Leiterbahn zu erkennen. Weitere Einzelheiten der Leiterbildübertragung werden nachfolgend anhand der FIG 2 bis 5 näher erläutert.

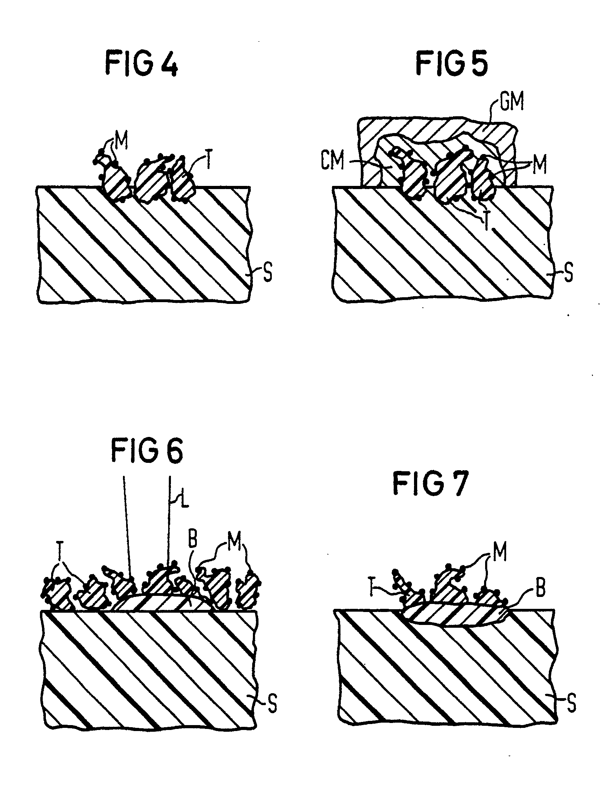

FIG 2 zeigt in stark vereinfachter schematischer Darstellung das Substrat S, auf dessen Oberfläche die einzelnen Partikel der Trägersubstanz T des Beschichtungsmittels gleichmäßig verteilt angeordnet sind. Ferner sind einzelne Partikel eines Metalles M zu erkennen, die auf die oberflächenreiche Trägersubstanz T aufgebracht sind. Geeignete Materialien sind beispielsweise Aktivkohle als Trägersubstanz T und Palladium als Metall M. Der entsprechend dem zu erzeugenden Leiterbild über die Oberfläche des Substrats S geführte Laserstrahl L führt zu einer oberflächlichen Aufschmelzung des Substrats S. Gemäß FIG 3 bewirkt diese Aufschmelzung eine feste Verankerung der Trägersubstanz T im Bereich des gewünschten Leiterbildes. Nachfolgend wird dann die nicht verankerte Trägersubstanz T durch Bürsten, Absprühen, Abwaschen in einem Ultraschallbad oder dergl. entfernt, so daß gemäß FIG 4 nur noch die verankerte Trägersubstanz T im Bereich des zu erzeugenden Leiterbildes auf dem Substrat S verbleibt. Die in dreidimensionaler Verteilung auf der verankerten Trägersubstanz T vorliegenden Partikel des Metalles M dienen dann als Keime für eine außenstromlose chemische Metallisierung des Leiterbildes. Das Leiterbild kann dabei vollständig durch chemische Metallabscheidung oder durch chemische und nachfolgende galvanische Metallabscheidung aufgebaut werden. Letzteres ist in FIG 5 dargestellt, wobei das chemisch abgeschiedene Metall mit CM und das galvanisch abgeschiedene Metall mit GM bezeichnet ist. Als Material für die Metalle CM und GM ist insbesondere Kupfer geeignet.

Die FIG 6 und 7 zeigen eine Variante, bei welcher die Trägersubstanz T mit einem Schmelzklebstoff als Bindemittel getränkt ist. Dieses Bindemittel B schmilzt dann durch die Einwirkung des Laserstrahls L auf und führt gemäß FIG 6 zu einer Verklebung der Trägersubstanz T mit der Oberfläche des Substrats S. Sofern es sich bei dem Substrat S weider um einen thermoplastischen Kunststoff handelt kann nach der Entfernung der nicht angeklebten Trägersubstanz T eine Wärmebehandlung durchgeführt werden, die gemäß FIG. 7 zu einem Einschmelzen in die Substratoberfläche und zu einer noch besseren Verankerung der Trägersubstanz T im Bereich des gewünschten Leiterbildes führt. Für die Wärmebehandlung können beispielsweise Mikrowellen verwendet werden. Als Bindemittel B werden dann insbesondere polare Polymere mit hoher Dielektrizitätskonstante verwendet. Die Mikrowellen wirken dann nur über dieses Bindemittel B auf das Substrat S ein, d. h. eine durch die Wärmebehandlung hervorgerufene Verformung des Substrats S kann mit Sicherheit ausgeschlossen werden. Für die Behandlung mit Mikrowellen als Bindemittel geeignete polare Polymere sind beispielsweise Polyamid und Polyimid.

Beispiel 1

Zur Herstellung eines Beschichtungsmittels wird von einem handelsüblichen Trägerkatalysator ausgegangen, welcher aus Aktivkohle mit darauf aufgebrachten Palladium besteht. Dabei sind etwa 10 Gew.-% Palladium auf 90 Gew.-% Aktivkohle verteilt angeordnet. Die Aktivkohle mit dem darauf aufgebrachten Palladium liegt in feinkörniger Form vor, wobei 30 % der Körner eine Korngröße unter 10 $\mu$m, 85 % der Körner eine Korngröße unter 50 $\mu$m und 98 % der Körner eine Korngröße unter 100 $\mu$m aufweisen. Das damit hergestellte Beschichtungsmittel enthält folgende Bestandteile:

```
30 Gew.-%          Aktivkohle + Palladium
 2 Gew.-%          Gelbpigment
25 bis 30 Gew.-%   Bindemittel
 1,5 % Gew.-%      Thixotropiermittel
Rest               Lösungsmittel
```

Als Bindemittel wurde ein Gemisch aus Maleinatharz und Polyvinylbutyral verwendet. Als Lösungsmittel wurde Äthanol verwendet.

Das vorstehend geschilderte Beschichtungsmittel wurde durch Tauchen auf ein Substrat aus Polyethersulfon aufgetragen. Die Übertragung eines Leiterbildes erfolgte mit der anhand der Fig. 1 dargestellten Anordnung mit Hilfe eines Laserstrahls. Anschließend wurde das überschüssige Beschichtungsmittel in einem Ultraschallreinigungsbad mit Isobutylmethylketon als Reinigungsflüssigkeit entfernt. Das Leiterbild wurde dann durch außenstromlose Kupferabscheidung mit einer Schichtdicke von 2 $\mu$m und galvanische Kupferabscheidung mit einer Schichtdicke von 33 $\mu$m aufgebaut.

5

Beispiel 2

Beim vorstehend beschriebenen Beispiel 1 wurde die Aktivkohle mit dem darauf aufgebrachten Palladium durch eine feinkörnigere Substanz mit einer mittleren Korngröße von etwa 4 μm ersetzt. Das resultierende Beschichtungsmittel wurde durch Spritzen mit einer Schichtdicke von etwa 4 bis 5 μm auf das Substrat aufgetragen.

Beispiel 3

Beim vorstehend beschriebenen Beispiel 2 wurde die Aktivkohle durch Calciumcarbonat ersetzt.

Beispiel 4

Beim Beispiel 2 wurden die Mengenverhältnisse von Aktivkohle zu Palladium geändert. Etwa 97 Gew.-% Aktivkohle dienen als Träger für 3 Gew.-% Palladium.

Beisiel 5

Beim Beispiel 3 wurden die Mengenverhältnisse von Calciumcarbonat zu Palladium geändert. Etwa 97 Gew.-% Calciumcarbonat dienen als Träger für 3 Gew.-% Palladium.

Beispiel 6

Das im Beispiel 4 verwendete Palladium wurde durch Platin ersetzt.

Beispiel 7

Das im Beispiel 5 verwendete Palladium wurde durch Platin ersetzt.

Beispiel 8

Bei dem Beispiel 1 wurde nach der Entfernung des überschüssigen Beschichtungsmittels eine Nachbehandlung in einem Ammoniumchloridbad vorgenommen. Diese Nachbehandlung führte zu einer wesentlichen Erhöhung der Haftfestigkeit der Leiterbahnen auf dem Substrat.
Die Nachbehandlung mit einem geeigneten Bad ist auch für die Beispiele 2 bis 7 anwendbar. BeimBeispiel 2 führte die Nachbehandlung mit Ammoniumchlorid zu einer Haftfestigkeit der Leiterbahnen von etwa 1 N/mm².

Beispiel 9

Bei dem Beispiel 1 wurde die Aktivkohle durch Leitruß ersetzt. Während es bei den übrigen elektrisch nicht leitenden Trägern bei einem zu großen Korn zu Unregelmäßigkeiten im Leiterbahnaufbau kommen kann, besteht an dieser Stelle durch den Leitruß die Leitfähigkeit fort, wenn auch in geringerem Maße als bei Metallen. Der Leitruß ersetzt also nicht die Metalle. Er ergänzt die Funktion der Metalle als Keime für die nachfolgende stromlose Metallisierung.

Beispiel 10

Bei dem Beispiel 1 wurde die Aktivkohle durch einen Kunststoff auf Acrylatbasis ersetzt.

6

Beispiel 11

Bei dem Beispiel 10 wurde der Kunststoff auf Acrylatbasis durch einen aus dem Material des Substrats bestehenden Kunststoff ersetzt. Bei Substrat und Träger aus Polyetherimid wurde eine sehr hohe Haftfestigkeit der Leiterbahnen auf dem Substrat erzielt.

Beispiel 12

Bei dem Beispiel 1 wurde ein allein aus dem Trägerkatalysator, d.h. aus Aktivkohle und Palladium bestehendes pulveriges Beschichtungsmittel verwendet. Dieses Beschichtungsmittel wurde auf das Substrat aufgestreut, mit dem Laserstrahl entsprechend dem Leiterbild verankert und dann chemisch und ggfs. galvanisch verkupfert. Hierdurch ließ sich das Verlöten oder Verkleben des Substrats verbessern.

Beispiel 13

Bei dem Beispiel 1 wurde das Beschichtungsmittel zunächst auf eine als Zwischenträger dienende Folie aufgebracht. Die Folie wurde dann auf das Substrat ausgelegt, worauf das Leiterbild mit dem Laser durch die Folie hindurch auf das Substrat übertragen wurde.

Beispiel 14

Bei dem Beispiel 1 wurde die Aktivkohle durch einen kunststoffgebundenen Katalysator ersetzt.

Beispiel 15

Bei dem Beispiel 14 wurde als kunststoffgebundener Katalysator ein zermahlener Ionenaustauscher verwendet, in den eine Palladium-Satz-Lösung eingebracht wurde und anschließend das Palladium chemisch zum nullwertigen Palladium reduziert wurde.

Beispiel 16

Bei dem Beispiel 14 wurde als kunststoffgebundener Katalysator zermahlener Polymerschaum mit großer Oberfläche verwendet, auf den Palladium abgeschieden wurde. Der Polymerschaum kann dabei offenzellig oder geschlossenenzellig sein.

Beispiel 17

Bei dem Beispiel 14 wurde als kunststoffgebundener Katalysator ein polymergebundener Palladium-Katalysator verwendet. Das Palladium kann dabei chelat- oder salzartig gebunden sein, wie Polyamide oder Polyacrylsäure und auf dem Polymer zu nullwertigem Palladium reduziert werden. Die Produkte können anschließend noch löslich sein und dann als Lösung auf das Substrat aufgebracht werden oder, wenn sie unlöslich sind, zunächst zermahlen und dann auf das Substrat aufgebracht werden.

Bei der Verwendung kunststoffgebundener Katalysatoren kann für das Zermahlen der Kunststoffe zu μm-großen Partikeln eine sogenannte Satzvermahlung angewandt werden. Die Polymeren, die sonst durch elektrostatische Aufladung wieder zusammenkleben können, werden dabei mit einem anorganischen Salz vermischt. Das Salz, welches das Zusammenkleben verhindert, wird nach dem Zermahlen mit Wasser wieder herausgelöst.

Schließlich soll noch darauf hinewiesen werden, daß die Verankerung des Leiterbildes auf dem Substrat durch Einwirkung von Wärme ggf. beträchtlich erhöht werden kann. So wurde bei Verwendung von Substraten aus Polyetherimid durch eine derartigen nach dem galvanischen Verkupfern durchgeführten Temperschritt die Haftfestigkeit um bis zu 50 % erhöht.

7

**Ansprüche**

1. Verfahren zum Aufbringen elektrisch leitender Druckbilder, insbesondere Leiterbilder, auf elektrisch isolierende Substrate, bei welchem ein metallhaltiges Beschichtungsmittel unter Einwirkung von Energiestrahlung entsprechend dem zu erzeugenden Druckbild auf das Substrat übertragen und chemisch metallisiert wird, dadurch **gekennzeichnet,** daß als Beschichtungsmittel eine nichtmetallische, körnige Trägersubstanz (T) mit darauf aufgebrachtem Metall (M) der Oxidationsstufe Null verwendet wird.

2. Verfahren nach Anspruch 1, **gekennzeichnet** durch die Verwendung einer feinkörnigen, oberflächenreichen Trägersubstanz (T).

3. Verfahren nach Anspruch 1 oder 2, **gekennzeichnet** durch die Verwendung einer Trägersubstanz (T) mit Korngrößen < 8 $\mu$m.

4. Verfahren nach Anspruch 2 oder 3, **gekennzeichnet** durch die Verwendung einer Trägersubstanz (T) mit Korngrößen > 1 $\mu$m.

5. Verfahren nach einem der vorhergehenden Ansprüche, **gekennzeichnet** durch die Verwendung einer Trägersubstanz (T) mit Korngrößen zwischen 2 $\mu$m und 4 $\mu$m.

6. Verfahren nach einem der vorhergehenden Ansprüche, dadurch **gekennzeichnet,** daß als Trägersubstanz (T) eine Substanz aus der Gruppe Aktivkohle, Leitruß, Calciumcarbonat, Kieselgur, Bentonit, Kaolin, Kieselgel, Aluminiumoxid, Titanoxid und Bimsstein einzeln oder in Gemischen verwendet wird.

7. Verfahren nach einem der Ansprüche 1 bis 5, dadurch **gekennzeichnet,** daß als Trägersubstanz (T) Aktivkohle verwendet wird.

8. Verfahren nach einem der Ansprüche 1 bis 5, dadurch **gekennzeichnet,** daß als Trägersubstanz (T) Calciumcarbonat verwendet wird.

9. Verfahren nach einem der Ansprüche 1 bis 5,
   **dadurch gekennzeichnet,** daß als Trägersubstanz (T) ein Kunststoff verwendet wird.

10. Verfahren nach Anspruch 9,
    **dadurch gekennzeichnet,** daß als Trägersubstanz (T) ein Kunststoff auf Acrylatbasis verwendet wird.

11. Verfahren nach einem der Ansprüche 1 bis 5, 9 oder 10,
    **gekennzeichnet durch** die Verwendung einer Trägersubstanz (T) aus dem Material des Substrats (S).

12. Verfahren nach einem der vorhergehenden Ansprüche, **gekennzeichnet** durch die Verwendung eines Beschichtungsmittels bei welchem 0,01 bis 10 Gew.-% Metall (M) auf 90 bis 99,9 Gew.-% Trägersubstanz (T) aufgebracht sind.

13. Verfahren nach einem der vorhergehenden Ansprüche, **gekennzeichnet** durch die Verwendung eines Metalles (M) aus der Gruppe der Edelmetalle.

14. Verfahren nach Anspruch 13, **gekennzeichnet** durch die Verwendung von Palladium als Metall (M).

15. Verfahren nach Anspruch 13, **gekennzeichnet** durch die Verwendung von Platin als Metall (M).

16. Verfahren nach einem der Ansprüche 1 bis 12, **gekennzeichnet** durch die Verwendung einer Edelmetall-Legierung als Metall (M).

17. Verfahren nach Anspruch 16, **gekennzeichnet** durch die Verwendung einer Edelmetall-Legierung mit einem unedleren Metall aus der Gruppe Blei, Zink, Nickel, Zinn und Kupfer.

18. Verfahren nach einem der vorhergehenden Ansprüche, **gekennzeichnet** durch die Verwendung eines Beschichtungsmittels das mindestens ein Bindemittel (B) enthält.

**19.** Verfahren nach Anspruch 18, **gekennzeichnet** durch die Verwendung eines Bindemittels (B) aus der Gruppe der Polyamide, Polyimide, Kollophoniumharze, Kohlenwasserstoffharze, Ketonharze und Polyvinylether allein oder in Gemischen.

**20.** Verfahren nach Anspruch 18, dadurch **gekennzeichnet,** daß als Bindemittel (B) Maleinatharz und/oder Polyvinylbutyral verwendet wird.

**21.** Verfahren nach Anspruch 18, dadurch **gekennzeichnet,** daß als Bindemittel (B) ein Schmelzklebstoff verwendet wird.

**22.** Verfahren nach Anspruch 18, dadurch **gekennzeichnet,** daß die Trägersubstanz (T) mit dem Bindemittel (B) getränkt wird.

**23.** Verfahren nach einem der vorhergehenden Ansprüche, **gekennzeichnet** durch die Verwendung eines Beschichtungsmittels das mindestens ein Lösemittel enthält.

**24.** Verfahren nach Anspruch 23, dadurch **gekennzeichnet,** daß als Lösemittel mindestens ein organisches Lösemittel verwendet wird.

**25.** Verfahren nach Anspruch 24, **gekennzeichnet** durch die Verwendung eines Lösemittels aus der Gruppe der Alkohole, Ester, Ketone, Kohlenwasserstoffe, Aliphate und Aromate allein oder in Gemischen.

**26.** Verfahren nach einem der Ansprüche 23 bis 25, **gekennzeichnet** durch die Verwendung eines Beschichtungsmittels das mindestens ein Thixotropiermittel enthält.

**27.** Verfahren nach einem der vorhergehenden Ansprüche, dadurch **gekennzeichnet,** daß das Beschichtungsmittel mit einer Schichtdicke zwischen 4 $\mu$m und 5 $\mu$m auf das Substrat (S) aufgebracht wird.

**28.** Verfahren nach einem der Ansprüche 23 bis 27, dadurch **gekennzeichnet,** daß das Beschichtungsmittel durch Tauchen auf das Substrat (S) aufgebracht wird.

**29.** Verfahren nach einem der Ansprüche 23 bis 27, dadurch **gekennzeichnet,** daß die Druckfarbe durch Spritzen auf das Substrat (S) aufgebracht wird.

**30.** Verfahren nach einem der vorhergehenden Ansprüche, dadurch **gekennzeichnet,** daß das Beschichtungsmittel mit Hilfe eines entsprechend dem zu erzeugenden Druckbild ablenkbaren Energiestrahls auf dem Substrat (S) verankert wird.

**31.** Verfahren nach Anspruch 30, dadurch **gekennzeichnet,** daß als Energiestrahl ein Laserstrahl (L) verwendet wird.

**32.** Verfahren nach Anspruch 31, dadurch **gekennzeichnet,** daß der Laserstrahl (L) mit einem $CO_2$-Laser erzeugt wird.

**33.** Verfahren nach Anspruch 32, dadurch **gekennzeichnet,** daß der $CO_2$-Laser mit einer mittleren Leistung zwischen 0,5 Watt und 8 Watt betrieben wird.

**34.** Verfahren nach Anspruch 31, dadurch **gekennzeichnet,** daß der Laserstrahl (L) mit einem Nd-YAG-Laser erzeugt wird.

**35.** Verfahren nach Anspruch 34, dadurch **gekennzeichnet,** daß der Nd-YAG-Lasser mit einer mittleren Leistung zwischen 0,2 Watt und 50 Watt betrieben wird.

**36.** Verfahren nach einem der Ansprüche 31 bis 35, dadurch **gekennzeichnet,** daß der Laserstrahl (L) derart fokussiert wird, daß sein Durchmesser an der Oberfläche des Substrats (S) zwischen 50 $\mu$m und 400 $\mu$m liegt.

**37.** Verfahren nach einem der vorhergehenden Ansprüche, dadurch **gekennzeichnet,** daß nach der Übertragung des Druckbildes das überschüssige Beschichtungsmittel wieder von der Oberfläche des Substrats (S) entfernt wird.

**38.** Verfahren nach Anspruch 37, dadurch **gekennzeichnet,** daß das überschüssige Beschichtungsmittel mit Hilfe einer Reinigungsflüssigkeit entfernt wird.

**39.** Verfahren nach Anspruch 38, dadurch **gekennzeichnet,** daß als Reinigungsflüssigkeit ein organisches Lösungsmittel verwendet wird.

**40.** Verfahren nach Anspruch 38 oder 39, dadurch **gekennzeichnet,** daß das überschüssige Beschichtungsmittel in einem Ultraschallbad entfernt wird.

**41.** Verfahren nach Anspruch 39 oder 40, dadurch **gekennzeichnet,** daß als Reinigungsflüssigkeit Isobutylmethylketon verwendet wird.

**42.** Verfahren nach Anspruch 40, dadurch **gekennzeichnet,** daß nach der Entfernung des überschüssigen Beschichtungsmittels die Verankerung des Druckbildes auf dem Substrat (S) durch die Einwirkung von Wärme erhöht wird.

**43.** Verfahren nach Anspruch 42 dadurch **gekennzeichnet,** daß die Wärme mit Hilfe von Mikrowellen erzeugt wird.

**44.** Verfahren nach einem der Ansprüche 37 bis 43, dadurch **gekennzeichnet,** daß nach der Entfernung des überschüssigen Beschichtungsmittels die Verankerung des Druckbildes auf dem Substrat (S) durch eine chemische Nachbehandlung erhöht wird.

**45.** Verfahren nach Anspruch 44, dadurch **gekennzeichnet,** daß die chemische Nachbehandlung in einem Ammoniumchloridbad vorgenommen wird.

**46.** Verfahren nach einem der vorhergehenden Ansprüche, dadurch **gekennzeichnet,** daß das auf das Substrat (S) übertragene Druckbild vollständig durch chemische Metallabscheidung aufgebaut wird.

**47.** Verfahren nach einem der Ansprüche 1 bis 46, dadurch **gekennzeichnet,** daß das auf das Substrat (S) übertragene Druckbild durch chemische und nachfolgende galvanische Metallabscheidung aufgebaut wird.

**48.** Verfahren nach Anspruch 46 oder 47, dadurch **gekennzeichnet,** daß das auf das Substrat (S) übertragene Druckbild durch die Abscheidung von Kupfer aufgebaut wird.

**49.** Metallhaltiges Beschichtungsmittel zum Aufbringen elektrisch leitender Druckbilder, insbesondere Leiterbilder auf elektrisch isolierende Substrate (S), insbesondere zur Durchführung des Verfahrens nach einem der Ansprüche 1 bis 48 dadurch **gekennzeichnet,** daß das Metall (M) in der Oxidationsstufe Null auf eine nichtmetallische, körnige Trägersubstanz (T) aufgebracht ist.

**50.** Metallhaltiges Beschichtungsmittel nach Anspruch 49, dadurch **gekennzeichnet,** daß zusätzlich ein Bindemittel (B) enthalten ist.

**51.** Metallhaltiges Beschichtungsmittel nach Anspruch 49 oder 50, dadurch **gekennzeichnet,** daß zusätzlich ein Lösemittel enthalten ist.

**52.** Metallhaltiges Beschichtungsmittel nach einem der Ansprüche 49 bis 50, dadurch **gekennzeichnet,** daß zusätzlich ein Thixotropiermittel enthalten ist.

**53.** Metallhaltiges Beschichtungsmittel nach einem der Ansprüche 49 bis 52, **gekennzeichnet** durch die Verwendung von Palladium als Metall (M).

# EP 0 277 325 B1

**Claims**

1. Method of applying electrically conductive printed patterns, preferably conductive patterns, onto electrically insulating substrates, in which under the influence of radiated energy a metal-containing coating material is transferred onto the substrate and chemically metallised in accordance with the printed pattern to be produced, characterised in that a non-metallic, grainy carrier substance (T) on which there is applied a metal (M) of oxidation number zero is used as a coating material.

2. Method according to Claim 1, characterised by the use of a fine-grained carrier substance (T) of large surface area.

3. Method according to Claim 1 or 2, characterised by the use of a carrier substance (T) with grain sizes < 8 $\mu$m.

4. Method according to Claim 2 or 3, characterised by the use of a carrier substance (T) with grain sizes > 1 $\mu$m.

5. Method according to one of the preceding claims, characterised by the use of a carrier substance (T) with grain sizes between 2 $\mu$m and 4 $\mu$m.

6. Method according to one of the preceding claims, characterised in that a substance from the group of activated carbon, conductive carbon black, calcium carbonate, kieselguhr, bentonite, kaolin, silica gel, alumina, titanium oxide and pumice is used individually or in mixtures as the carrier substance (T).

7. Method according to one of Claims 1 to 5, characterised in that activated carbon is used as the carrier substance (T).

8. Method according to one of Claims 1 to 5, characterised in that calcium carbonate is used as the carrier substance (T).

9. Method according to one of Claims 1 to 5, characterised in that a plastic is used as the carrier substance (T).

10. Method according to Claim 9, characterised in that an acrylate-based plastic is used as the carrier substance (T).

11. Method according to one of Claims 1 to 5, 9 or 10, characterised by the use of a carrier substance (T) made from the material of the substrate (S).

12. Method according to one of the preceding claims, characterised by the use of a coating material in which 0.01 to 10% by weight of metal (M) is applied to 90 to 99.9% by weight of carrier substance (T).

13. Method according to one of the preceding claims, characterised by the use of a metal (M) from the group of noble metals.

14. Method according to Claim 13, characterised by the use of palladium as the metal (M).

15. Method according to Claim 13, characterised by the use of platinum as the metal (M).

16. Method according to one of Claims 1 to 12, characterised by the use of a noble metal alloy as the metal (M).

17. Method according to Claim 16, characterised by the use of a noble metal alloy with a less noble metal from the group of lead, zinc, nickel, tin and copper.

18. Method according to one of the preceding claims, characterised by the use of a coating material that contains at least one binder (B).

11

19. Method according to Claim 18, characterised by the use of a binder (B) from the group of the polyamide, polyimide, resins, hydrocarbon resins, ketone resins and polyvinyl ether alone or in mixtures.

20. Method according to Claim 18, characterised in that maleate resin and/or polyvinyl butyral are used as the binder (B).

21. Method according to Claim 18, characterised in that a hot-melt adhesive is used as the binder (B).

22. Method according to Claim 18, characterised in that the carrier substance (T) is impregnated with the binder (B).

23. Method according to one of the preceding claims, characterised by the use of a coating material which contains at least one solvent.

24. Method according to Claim 23, characterised in that at least one organic solvent is used as the solvent.

25. Method according to Claim 24, characterised by the use of a solvent from the group of the alcohols, esters, ketones, hydrocarbons, aliphatic compounds and aromatic compounds alone or in mixtures.

26. Method according to one of Claims 23 to 25, characterised by the use of a coating material which contains at least one thixotropic agent.

27. Method according to one of the preceding claims, characterised in that the coating material is applied to the substrate () with a layer thickness between 4 $\mu$m and 5 $\mu$m.

28. Method according to one of Claims 23 to 27, characterised in that the coating material is applied to the substrate (S) by immersion.

29. Method according to one of Claims 23 to 27, characterised in that the print colour is applied to the substrate (S) by spraying.

30. Method according to one of the preceding claims, characterised in that the coating material is anchored on the substrate (S) with the aid of a beam of energy that can be deflected in accordance with the printed pattern to be produced.

31. Method according to Claim 30, characterised in that a laser beam (L) is used as the beam of energy.

32. Method according to Claim 31, characterised in that a laser beam (L) is produced by means of a $CO_2$-laser.

33. Method according to Claim 32, characterised in that the $CO_2$-laser is operated at a mean power between 0.5 watts and 8 watts.

34. Method according to Claim 31, characterised in that the laser beam (L) is produced by means of a Nd-YAG laser.

35. Method according to Claim 34, characterised in that the Nd-YAG laser is operated at a mean power between 0.2 watts and 50 watts.

36. Method according to one of Claims 31 to 35, characterised in that the laser beam (L) is focused in such a way that its diameter on the surface of the substrate (S) is between 50 $\mu$m and 400 $\mu$m.

37. Method according to one of the preceding claims, characterised in that after the transfer of the printed pattern the excess coating material is removed once again from the surface of the substrate (S).

38. Method according to Claim 37, characterised in that the excess coating material is removed with the aid of a washing liquid.

EP 0 277 325 B1

**39.** Method according to Claim 38, characterised in that an organic solvent is used as the washing liquid.

**40.** Method according to Claim 38 or 39, characterised in that the excess coating material is removed in an ultrasonic bath.

**41.** Method according to Claim 39 or 40, characterised in that isobutyl methyl ketone is used as the washing liquid.

**42.** Method according to Claim 40, characterised in that after the removal of the excess coating material the anchoring of the printed pattern on the substrate (S) is enhanced by the influence of heat.

**43.** Method according to Claim 42, characterised in that the heat is produced with the aid of microwaves.

**44.** Method according to one of Claims 37 to 43, characterised in that after the removal of the excess coating material the anchoring of the printed pattern on the substrate (S) is enhanced by means of chemical aftertreatment.

**45.** Method according to Claim 44, characterised in that the chemical aftertreatment is undertaken in an aluminium chloride bath.

**46.** Method according to one of the preceding claims, characterised in that the printed pattern transferred to the substrate (S) is built up entirely by chemical metal deposition.

**47.** Method according to one of Claims 1 to 46, characterised in that the printed pattern transferred to the substrate (S) is built up by chemical and subsequent galvanic metal deposition.

**48.** Method according to Claim 46 or 47, characterised in that the printed pattern transferred to the substrate (S) is built up by the deposition of copper.

**49.** Metal-containing coating material for applying electrically conductive printed patterns, preferably conductive patterns on electrically insulating substrates (S), preferably for carrying out the method according to one of Claims 1 to 48, characterised in that the metal (M) is applied at the zero oxidation number to a non-metallic, grainy carrier substance (T).

**50.** Metal-containing coating material according to Claim 49, characterised in that a binder (B) is additionally contained.

**51.** Metal-containing coating material according to Claim 49 or 50, characterised in that a solvent is additionally contained.

**52.** Metal-containing coating material according to one of Claims 49 to 50, characterised in that a thixotropic agent is additionally contained.

**53.** Metal-containing coating material according to one of Claims 49 to 52, characterised by the use of palladium as the metal (M).


**Revendications**

**1.** Procédé pour déposer des motifs imprimés électriquement conducteurs, notamment des motifs de conducteurs, sur des substrats électriquement isolants, selon lequel on transfère une substance de revêtement à teneur metallique est transférée sur le substrat, sous l'action d'un rayonnement énergétique, et en conformité avec le motif imprimé devant être produit, et est métallisée par voie chimique, caractérisé par le fait qu'on utilise comme substance de revêtement, une substance de support granuleuse non métallique (T) sur laquelle est déposé un métal (M) présentant le niveau d'oxydation zéro.

**2.** Procédé suivant la revendication 1, caractérisé par le fait qu'on utilise une substance de support à grains fins (T) possédant une surface étendue.

3. Procédé suivant la revendication 1 ou 2, caractérisé par le fait qu'on utilise une substance de support (T) possédant des grains d'une taille < 8 $\mu$m.

4. Procédé suivant la revendication 2 ou 3, caractérisé par le fait qu'on utilise une substance de support (T) possédant des grains d'une taille > 1 $\mu$m.

5. Procédé suivant l'une des revendications précédentes, caractérisé par le fait qu'on utilise une substance de support (T) possédant des grains d'une taille comprise entre 2 $\mu$m et 4 $\mu$m.

6. Procédé suivant l'une des revendications précédentes, caractérisé par le fait qu'on utilise comme substance de support (T) une substance tirée du groupe charbon actif, suie conductrice, carbonate de calcium, kieselguhr, bentonite, kaolin, gel de silice, oxyde d'aluminium, oxyde de titane et pierre ponce, individuellement ou en mélange.

7. Procédé suivant l'une des revendications 1 à 5, caractérisé par le fait qu'on utilise comme substance de support (T) du charbon actif.

8. Procédé suivant l'une des revendications 1 à 5, caractérisé par le fait qu'on utilise comme substance de support (T), du carbonate de calcium.

9. Procédé suivant l'une des revendications 1 à 5, caractérisé par le fait qu'on utilise comme substance de support (T), une matière plastique.

10. Procédé suivant la revendication 9, caractérisé par le fait qu'on utilise comme substance de support (T), une matière plastique à base d'acrylate.

11. Procédé suivant l'une des revendications 1 à 5, 9 ou 10, caractérisé par le fait qu'on utilise une substance de support (T) formée par le matériau du substrat (S).

12. Procédé suivant l'une des revendications précédentes, caractérisé par le fait qu'on utilise une substance de revêtement dans laquelle on dépose un métal (M), intervenant pour 0,01 à 10 % en poids, sur une substance de support (T), intervenant pour 90 à 99,9 % en poids.

13. Procédé suivant l'une des revendications précédentes, caractérisé par le fait qu'on utilise un métal (M) faisant partie du groupe des métaux précieux.

14. Procédé suivant la revendication 13, caractérisé par le fait qu'on utilise comme métal (M), du palladium.

15. Procédé suivant la revendication 13, caractérisé par le fait qu'on utilise comme métal (M), du platine.

16. Procédé suivant l'une des revendications 1 à 12, caractérisé par le fait qu'on utilise comme métal (M), un alliage de métaux précieux.

17. Procédé suivant la revendication 16, caractérisé par le fait qu'on utilise un alliage d'un métal précieux avec un métal non précieux tiré du groupe : plomb, zinc, nickel, étain et cuivre.

18. Procédé suivant l'une des revendications précédentes, caractérisé par le fait qu'on utilise une substance de revêtement qui contient au moins un liant (B).

19. Procédé suivant la revendication 18, caractérisé par le fait qu'on utilise un liant (B) tiré du groupe incluant les polyamides, les polyimides, les résines de collophane, les résines d'hydrocarbures, les résines cétoniques et l'éther polyvinylique, individuellement ou en mélange.

20. Procédé suivant la revendication 18, caractérisé par le fait qu'on utilise comme liant (B) une résine maléique et/ou du polyvinylbutyral.

21. Procédé suivant la revendication 18, caractérisé par le fait qu'on utilise comme liant (B), une colle fusible.

22. Procédé suivant la revendication 18, caractérisé par le fait qu'on imprègne la substance de support (T) avec le liant (B).

23. Procédé suivant l'une des revendications précédentes, caractérisé par le fait qu'on utilise une substance de revêtement qui contient au moins un solvant.

24. Procédé suivant la revendication 23, caractérisé par le fait qu'on utilise comme solvant, au moins un solvant organique.

25. Procédé suivant la revendication 24, caractérisé par le fait qu'on utilise un solvant organique tiré du groupe incluant les alcools, les esters, les cétones, les hydrocarbures, les composés acycliques et les corps à noyau benzénique, individuellement ou en mélange.

26. Procédé suivant l'une des revendications 23 à 25, caractérisé par le fait qu'on utilise une substance de revêtement qui contient au moins un agent thixotrope.

27. Procédé suivant l'une des revendications précédentes, caractérisé par le fait qu'on dépose la substance de revêtement avec une épaisseur de couche comprise entre 4 $\mu$m et 5 $\mu$m sur le substrat (S).

28. Procédé suivant l'une des revendications 23 à 27, caractérisé par le fait qu'on dépose la substance de revêtement par immersion sur le substrat (S).

29. Procédé suivant l'une des revendications 23 à 27, caractérisé par le fait qu'on dépose l'encre d'impression par projection sur le substrat (S).

30. Procédé suivant l'une des revendications précédentes, caractérisé par le fait qu'on dépose la substance de revêtement sur le substrat (S) à l'aide d'un faisceau d'énergétique pouvant être dévié conformément au motif imprimé devant être produit.

31. Procédé suivant la revendication 30, caractérisé par le fait qu'on utilise, comme faisceau d'énergétique, un faisceau laser (L).

32. Procédé suivant la revendication 31, caractérisé par le fait que le faisceau laser (L) est produit au moyen d'un laser à $CO_2$.

33. Procédé suivant la revendication 32, caractérisé par le fait qu'on fait fonctionner le laser à $CO_2$ avec une puissance moyenne comprise entre 0,5 watt et 8 watt.

34. Procédé suivant la revendication 31, caractérisé par le fait que le faisceau laser (L) est produit avec un laser au Nd-YAG.

35. Procédé suivant la revendication 34, caractérisé par le fait qu'on fait fonctionner le laser au Nd-YAG avec une puissance moyenne comprise entre 0,2 watt et 50 watts.

36. Procédé suivant l'une des revendications 31 à 35, caractérisé par le fait que le faisceau laser (L) est focalisé de manière que son diamètre sur la surface du substrat (S) soit compris entre 50 $\mu$m et 400 $\mu$m.

37. Procédé suivant l'une des revendications précédentes, caractérisé par le fait qu'après le transfert du motif imprimé, on élimine à nouveau la substance de revêtement en excès, de la surface du substrat (S).

38. Procédé suivant la revendication 37, caractérisé par le fait qu'on élimine la substance de revêtement en excès à l'aide d'un liquide de nettoyage.

15

**39.** Procédé suivant la revendication 38, caractérisé par le fait qu'on utilise comme liquide de nettoyage un solvant organique.

**40.** Procédé suivant la revendication 38 ou 39, caractérisé par le fait qu'on élimine la substance de revêtement en excès dans un bain à ultrasons.

**41.** Procédé suivant la revendication 39 ou 40, caractérisé par le fait qu'on utilise comme liquide de nettoyage, de l'isobutylméthylcétone.

**42.** Procédé suivant la revendication 40, caractérisé par le fait qu'après élimination de la substance de revêtement en excès, on accroît l'ancrage du motif imprimé sur le substrat (S) par un effet thermique.

**43.** Procédé suivant la revendication 42, caractérisé par le fait que la chaleur est produite à l'aide de micro-ondes.

**44.** Procédé suivant l'une des revendications 37 à 43, caractérisé par le fait qu'après élimination de la substance de revêtement en excès, on accroît l'ancrage du motif imprimé sur le substrat (S) au moyen d'un post-traitement chimique.

**45.** Procédé suivant la revendication 44, caractérisé par le fait qu'on réalise le post-traitement chimique dans un bain de chlorure d'ammonium.

**46.** Procédé suivant l'une des revendications précédentes, caractérisé par le fait que le motif imprimé transféré sur le substrat (S) est formé entièrement au moyen d'un dépôt métallique par voie chimique.

**47.** Procédé suivant l'une des revendications 1 à 46, caractérisé par le fait que le motif imprimé transféré sur le substrat (S) est formé au moyen d'un dépôt métallique par voie chimique, puis par voie galvanique.

**48.** Procédé suivant la revendication 46 ou 47, caractérisé par le fait que le motif imprimé transféré sur le substrat (S) est formé au moyen du dépôt de cuivre.

**49.** Substance de revêtement à teneur métallique pour le dépôt de motifs imprimés électriquement conducteurs, notamment de motifs de conducteurs sur des substrats électriquement isolants (S), notamment pour la mise en oeuvre du procédé suivant l'une des revendications 1 à 48, caractérisée par le fait qu'on dépose le matériau (M) possédant un niveau d'oxydation zéro sur une substance de support granuleuse non métallique (T).

**50.** Substance de revêtement à teneur métallique suivant la revendication 49, caractérisée par le fait quelle contient en outre un liant (B).

**51.** Substance de revêtement à teneur métallique suivant la revendication 49 ou 50, caractérisée par le fait qu'elle contient en outre un solvant.

**52.** Substance de revêtement à teneur métallique suivant l'une des revendications 40 à 50, caractérisée par le fait qu'elle contient en outre un agent thixotrope.

**53.** Substance de revêtement à teneur métallique suivant l'une des revendications 49 à 52, caractérisée par le fait qu'on utilise du palladium en tant que métal (M).

16

**FIG1**

**FIG 2**

**FIG 3**

# FIG 4

# FIG 5

# FIG 6

# FIG 7